# EUROPÄISCHE PATENTSCHRIFT

(11) **EP 2 499 886 B1**
(45) Veröffentlichungstag und Bekanntmachung des Hinweises auf die Patenterteilung: **16.04.2014**
(21) Anmeldenummer: 10801586.8
(22) Anmeldetag: 29.12.2010
(51) Int. Cl.: H05K 3/04, B23C 1/04, B44B 3/02, B23C 3/30, H01L 35/32, H01L 35/34

(54) **VERFAHREN UND VORRICHTUNG ZUR STRUKTURIERUNG EINER AUF EINEM SUBSTRAT ANGEORDNETEN LAGE**
METHOD AND DEVICE FOR STRUCTURING A LAYER ARRANGED ON A SUBSTRATE
PROCÉDÉ ET DISPOSITIF POUR STRUCTURER UNE COUCHE DISPOSÉE SUR UN SUBSTRAT

(30) Priorität: 21.01.2010 DE 102010005340
(43) Veröffentlichungstag der Anmeldung: 19.09.2012
(73) Patentinhaber: O-Flexx Technologies GmbH, 47059 Duisburg (DE)
(72) Erfinder: ULLAND, Holger, Albert, 47877 Willich (DE)
(74) Vertreter: Kohlmann, Kai
(86) Internationale Anmeldenummer: PCT/EP2010/070831
(87) Internationale Veröffentlichungsnummer: WO 2011/088955

(56) Entgegenhaltungen:
- EP-A2- 0 220 646
- EP-A2- 0 470 350
- WO-A1-2008/082322
- WO-A1-2009/117979
- GB-A- 933 385
- US-A- 4 408 510
- US-A- 6 006 739

## Beschreibung

Die Erfindung betrifft ein Verfahren und eine Vorrichtung zur Strukturierung einer auf einem Substrat angeordneten Lage in mehrere voneinander getrennte Bereiche.

Die Strukturierung von einer auf einem Substrat angeordneten Lage ist beispielsweise bei der Herstellung von Leiterplatten als Träger für elektronische Bauteile erforderlich. Das Substrat besteht aus einem elektrisch isolierenden Material, auf dem sich eine Kupferschicht befindet. Die Leiterbahnen und Lötflächen werden durch eine Strukturierung der Kupferschicht hergestellt.

Die vorliegende Erfindung bezieht sich insbesondere auf die Strukturierung der elektrisch leitfähigen Lagen auf Substraten zur Herstellung von Modulen mit mehreren elektrisch in Serie geschalteten Dünnschicht-Thermoelementen. In der EP 1 287 566 B1 wird ein Dünnschicht-Thermoelement offenbart, das aus mindestens einer n-dotierten und mindestens einer p-dotierten Halbleiterschicht aus thermoelektrischem Material unter Ausbildung wenigstens eines sich entlang einer Grenzschicht ausbildenden pn-Übergangs besteht. Ein Temperaturgradient ist parallel zur Grenzschicht zwischen einer heißen und einer kalten Seite des Thermoelementes anlegbar. Um die Thermoelemente zu einem Modul miteinander zu verschalten, ist ein Substrat mit mehreren elektrisch und thermisch leitfähigen Bereichen erforderlich, die durch isolierende Trennfugen zwischen den Bereichen thermisch und elektrisch voneinander getrennt sind.

Insbesondere bei der Leiterplattenherstellung, jedoch auch in der Mikroelektronik kommen zur Strukturierung der Lage Fotolacke zum Einsatz. Auf die vollflächig das Substrat abdeckende leitfähige Lage wird eine dünne Schicht des lichtempfindlichen Fotolacks aufgebracht. Nach der Belichtung des Fotolacks durch eine Maske mit der gewünschten Struktur, beispielsweise in Form eines Leiterplattenlayouts, werden abhängig von dem verwendeten Fotolack entweder die belichteten oder die unbelichteten Teile des Fotolacks mit einer Entwicklerlösung entfernt. Bringt man das so vorbehandelte Substrat in eine geeignete Ätzlösung, so wird nur der freigelegte Teil der elektrisch leitfähigen Lage angegriffen, während die vom Fotolack bedeckten Anteile der Lage erhalten bleiben, weil der Fotolack gegen die Ätzlösung beständig ist. Schließlich muss der Fotolack von den nunmehr getrennten Bereichen der elektrisch leitfähigen Lage wieder entfernt werden. Diesen Vorgang nennt man Veraschung. Die Veraschung kann beispielsweise nass-chemisch erfolgen.

Ein wesentlicher Nachteil der bekannten Strukturierungsverfahren besteht darin, dass die Maskierung und deren Entfernung hohe Kosten und eine lange Verfahrensdauer verursachen. Soweit chemische Ätzprozesse erforderlich sind, sind darüber hinaus Maßnahmen zum Schutz der Umwelt zu ergreifen.

Verfahren zur Strukturierung einer auf einem Substrat angeordneten metallischen Lage in mehrere voneinander getrennte Bereiche mit Hilfe von Zerspannungswerkzeugen vermeiden die vorgenannten Nachteile.

Die DE 10 2008 016 340 B3 offenbart eine auf einem Substrat angeordnete elektrisch leitfähige Lage, in die mit Hilfe eines Zerspanwerkzeugs eine Längsnut eingebracht wird. Hierdurch wird die leitfähige Lage in zwei voneinander getrennte Bereiche strukturiert. Das Zerspanwerkzeug ist an einem in verschiedenen Raumachsen verfahrbaren Bearbeitungskopf angeordnet, um das ortsfeste Substrat zu strukturieren.

Die DE 10 76 212 A offenbart ein Verfahren zur Herstellung von elektrisch leitenden Schaltverbindungen aus einer Metallfolie, die fest auf einer Isolierstoffplatte haftet. Zu diesem Zweck wird die Isolierstoffplatte mit der Metallfolie auf ein Fließband aufgegeben. Die auf dem Fließband fortbewegte Schaltplatte erreicht zunächst eine erste Bearbeitungsstufe mit mehreren Bohreinrichtungen. Sobald die Schaltplatte alle erforderlichen Bohrungen enthält, wird sie zu einer ersten Fräseinrichtung mit dem Fließband gefördert. Die Fräseinrichtung enthält mehrere ortsfeste Brücken, an denen Fräsköpfe angebracht sind. Die Fräsungen in Längsrichtung der Schaltplatte werden während der Bewegung des Fließbandes ausgeführt. Zur Erzeugung von Fräsungen in der Metallfolie, die rechtwinklig zu den von der ersten Fräseinrichtung erzeugten Fräsungen stehen, wird die Schaltplatte in einer Bearbeitungsstufe zunächst um 90° gedreht, bevor sie einer zweiten Fräseinrichtung zugeführt wird.

Aus der GB 1,135,982 A ist ein Verfahren und eine Vorrichtung zur Strukturierung einer auf einem flexiblem Substrat angeordneten elektrisch leitfähigen Metallfolie in mehrere voneinander getrennte Bereiche bekannt, wobei die Metallfolie mit Hilfe eines Zerspanwerkzeugs abgetragen wird. Das Substrat wird dabei über eine dem Zerspanwerkzeug gegenüberliegende Stützfläche geführt.

Die GB 933 385 A offenbart ein Verfahren und eine Vorrichtung zur Strukturierung eines Laminats. Das Laminat besteht aus einer isolierenden Plastiklage, auf der eine Dünnschicht aus Metall haftet. Die metallische Dünnschicht wird in mehrere voneinander getrennte Bereiche, nämlich streifenförmige Leiterbahnen strukturiert, wobei die Dünnschicht aus Metall zwischen voneinander zu trennenden Bereichen mit Hilfe einer Fräsrolle abgetragen wird, die isolierende Plastiklage auf der der Fräsrolle gegenüberliegenden Seite auf einer Oberfläche aufliegt, die Fräsrolle soweit in Richtung der Oberfläche und relativ zu der Dünnschicht aus Metall in deren Ebene bewegt wird, dass die Dünnschicht aus Metall zwischen den voneinander zu trennenden streifenförmigen Leiterbahnen vollständig abgetragen wird und die Relativbewegung des Laminats in der Ebene der abzutragenden Dünnschicht aus Metall durch eine gerichtete Bewegung des Laminats erzeugt wird.

Ausgehend von dem Stand der Technik nach der GB 933 385 A liegt der Erfindung die Aufgabe zu Grunde, ein Verfahren der eingangs erwähnten Art anzugeben, das kostengünstig und mit kürzerer Verfahrensdauer eine Strukturierung der auf dem Substrat angeordneten Lage sowohl in einer Längsrichtung des Substrats als auch quer dazu in mehrere voneinander getrennte Bereiche ermöglicht, das insbesondere als kontinuierlicher Prozess automatisierbar ist, wobei während dieser Strukturierung ein Unterbrechen des Vorschubs des Substrats nicht erforderlich ist. Außerdem soll eine Vorrichtung zur Durchführung des Verfahrens angegeben werden.

Diese Aufgabe wird bei einem Verfahren mit den Merkmalen des Anspruchs 1 dadurch gelöst, dass durch den vollständigen Abtrag der Lage zwischen den voneinander zu trennenden Bereichen sich zwischen den Bereichen isolierende Trennfugen in Längs- und Querrichtung des Substrats (1) ergeben, die Relativbewegung jedes der im Anspruch gennanten einen oder mehreren zweiten Zerspanwerkzeuge in der Ebene der abzutragenden Lage mit Hilfe eines Positioniersystem dadurch erzeugt wird, dass jedes der vorgenannten zweiten Zerspanwerkzeuge quer zu der Bewegungsrichtung des Substrats bewegt wird, wobei jedes der vorgenannten sich quer zu der Bewegungsrichtung des Substrats bewegenden zweiten Zerspanwerkzeuge von dem Positioniersystem zugleich mit übereinstimmender Geschwindigkeit und Bewegungsrichtung wie das Substrat bewegt wird und das abgetragene Material entfernt wird.

Die elektrisch leitfähige, insbesondere metallische Lage weist eine Stärke im Bereich von 0,1 bis 1.000 µm auf. Das insbesondere aus elektrisch isolierendem Material bestehende Substrat weist eine Stärke in einem Bereich von 10 bis 10.000 µm auf. Die elektrisch leitfähige Lage zwischen den voneinander zu trennenden Bereichen wird mechanisch mit Hilfe der Zerspanwerkzeuge abgetragen, ohne dabei das Substrat zu durchtrennen. Um dies zu erreichen liegt das Substrat auf der jedem Zerspanwerkzeug gegenüberliegenden Seite auf einer Oberfläche auf, die als Referenzfläche für die Positionierung der Zerspanwerkzeuge dient. Jedes Zerspanwerkzeug wird soweit in Richtung dieser Referenzoberfläche bewegt, dass die elektrisch leitfähige Lage zwischen den voneinander zu trennenden Bereichen stets vollständig abgetragen wird.

Fertigungsbedingt weist das Substrat stets eine gewisse Toleranz von der Nenn-Stärke auf. Sofern der Abstand jedes Zerspanwerkzeugs in Bezug zu der Referenzoberfläche kleiner als die geringste Stärke des Substrats gewählt wird, ist stets der vollständige Abtrag der elektrisch leitfähigen Lage gewährleistet. Der Abstand des Zerspanwerkzeugs von der Referenzoberfläche wird vorzugsweise so gewählt, dass er nur geringfügig kleiner als die geringste Stärke (unteres Grenzmaß) des Substrates ist. Hierdurch wird gewährleistet, dass von dem tragenden Substrat so wenig Material wie möglich abgetragen und daher dessen Tragfunktion nicht beeinträchtigt wird.

Abhängig von der Breite des Zerspanwerkzeugs bilden sich zwischen den voneinander getrennten Bereichen isolierende Stege, die der Breite des Zerspanwerkzeugs entsprechen. Die Breite kann durch das Zerspanwerkzeug beispielsweise in einem Bereich zwischen 100 µm und einigen Millimetern gewählt werden.

Die Automatisierung des Verfahrens wird durch die Auflage des Substrats auf der Referenzoberfläche ermöglicht. Hierdurch kann das Zerspanwerkzeug mit an sich bekannten Positioniersystemen zu der Referenzoberfläche ausgerichtet werden. Die Relativbewegung der Zerspanwerkzeuge in der Ebene der abzutragenden Lage wird ebenfalls mit Hilfe eines Positioniersystems und durch eine gerichtete Bewegung des insbesondere bahnförmigen Substrats automatisiert.

Während und/oder nach dem Abtragen der elektrisch leitfähigen Lage ist es erforderlich, dass das abgetragene Material von dem Substrat entfernt wird. Hierzu können Ultraschall-Reinigungsverfahren oder mechanische Reinigungsverfahren, beispielsweise mit rotierenden Bürsten, eingesetzt werden.

Um die einwandfreie Funktion der hergestellten Strukturen zu überprüfen, kann dem Herstellungsverfahren eine optische oder taktile Inspektion nachgeordnet werden, mit der die einwandfreie Trennung der Bereiche in der elektrisch leitfähigen Lage überprüft wird.

Das erfindungsgemäße Verfahren eignet sich insbesondere zum Abtrag von Lagen mit einer relativ großen Stärke im Bereich von bis zu 100 µm, die sich mit den herkömmlichen Ätztechnologien nicht oder nur in sehr langwierigen Prozessen entfernen lassen.

Eine einfache Möglichkeit die Relativbewegung zwischen mindestens einem der Spanwerkzeuge und der elektrisch leitfähigen Lage zu erzeugen besteht darin, dass das bahnförmige Substrat über die als Referenz dienende Oberfläche geführt wird. Es kann sich beispielsweise um die Oberfläche einer plattenförmigen Auflage oder einer zylinderförmigen Rolle handeln. Das in einem definierten Abstand zu dieser Oberfläche positionierte Zerspanwerkzeug erzeugt längs der Bewegungsrichtung des Substrats die Trennfuge zwischen den voneinander zu trennenden Bereichen der elektrisch leitfähigen Lage. Bei einer vorzugsweise gradlinigen Bewegung des Substrats über die Oberfläche weist die Trennfuge die Form eines Stegs in der Breite des Zerspanwerkzeugs auf.

Für die quer zur Bewegungsrichtung des Substrats in die elektrisch leitfähige Lage einzubringenden Trennfugen, wird mindestens eines der Zerspanwerkzeuge quer zu der Bewegungsrichtung in der Ebene der elektrisch leitenden Lage bewegt.

Um das Verfahren in einem Rolle- zu - Rollebetrieb zu automatisieren, wird in vorteilhafter Ausgestaltung der Erfindung ein bahnförmiges, flexibles Substrat verwendet. Das Substrat besteht vorzugsweise aus einer Trägerfolie mit einer Stärke in einem Bereich von 10 bis 10.000 µm. Um die gewünschten isolierenden Eigenschaften zu gewährleisten, besteht die Trägerfolie beispielsweise aus Kunststoffen, wie Polyimid, Polypropylen, Teflon, Polyamid oder Polyester. Auf der Trägerfolie wird die elektrisch leitfähige Lage vor deren Strukturierung als festhaftende Schicht, insbesondere vollflächig aufgebracht. Die Beschichtung kann beispielsweise im Wege eines Plasmabeschichtungsprozesses, galvanisch oder im Wege eines Druckverfahrens aufgebracht werden. Die elektrisch leitfähige Lage kann jedoch auch als elektrisch leitfähige Folie auf die Trägerfolie auflaminiert werden. In beiden Fällen lässt sich das zu strukturierende, insbesondere bahnförmige Substrat mit metallischer Lage in großen Mengen kostengünstig herstellen und auf Rollen bevorraten.

Zur Herstellung der in Längs- und Querrichtung des bahnförmigen Substrates verlaufenden Trennfugen eignen sich insbesondere rotierende Fräs- oder Sägewerkzeuge. Die Schneiden des rotierenden Fräswerkzeugs können sich in Bewegungsrichtung oder entgegen der Bewegungsrichtung des Substrats bewegen. Um einen einwandfreien Abtrag zu gewährleisten, weicht die Vorschubgeschwindigkeit des Substrats von der Bewegungsgeschwindigkeit der Schneiden des rotierenden Fräswerkzeugs ab. Vorzugsweise ist die Bewegungsgeschwindigkeit der Schneiden wesentlich höher als die Vorschubgeschwindigkeit des Substrats. Dies gilt in gleicher Weise für ein rotierendes Sägeblatt.

Eine Vorrichtung zur Durchführung des Verfahrens ergibt sich aus den Merkmalen des Anspruchs 7.

Jedes der im Anspruch genannten einen oder mehreren ersten Zerspanwerkzeuge ist an einem Positioniersystem angeordnet, mit dem die vorgenannten ersten Zerspanwerkzeuge zumindest in Richtung der ortsfesten Positioniereinrichtung oder von deren Oberfläche weg bewegbar sind.

Jedes der im Anspruch genannten einen oder mehreren zweiten Zerspanwerkzeuge ist an einem Positioniersystem angeordnet, das ein mehrachsiges Linearsystem ist, entlang dessen Achsen jedes zweite Zerspanwerkzeug nicht nur in Richtung der Oberfläche der Positioniereinrichtung oder von deren Oberfläche weg, sondern auch parallel zu deren Oberfläche bewegbar ist. Mit dem mehrachsigen Linearsystem, lässt sich jedes der vorgenannten zweiten Zerspanwerkzeuge quer zu der Bewegungsrichtung des Substrats bewegen, wobei jedes sich quer zu der Bewegungsrichtung des Substrats bewegende zweite Zerspanwerkzeug von dem Positioniersystem zugleich mit übereinstimmender Geschwindigkeit und Bewegungsrichtung wie das Substrat bewegt wird.

Eine vorteilhafte Vorrichtung zur Durchführung des Verfahrens mit einem von Rolle zu Rolle geführten bahnförmigen Substrat weist mindestens eine ortsfeste Positioniervorrichtung mit einer Oberfläche auf, über die das Substrat in einer Bewegungsrichtung geführt wird. Für die Strukturierung quer zur Bewegungsrichtung des Substrats, muss zusätzlich mindestens ein quer zur Bewegungsrichtung bewegliches Zerspanwerkzeug aktiviert werden.

Die Vorschubbewegung des Substrats kann beispielsweise durch Antriebsrollen erfolgen, die an dem Substrat anliegen. Ein flexibles Substrat kann beispielsweise auf eine angetriebene Spule aufgewickelt und dabei über die Positioniereinrichtung geführt und von dem gegenüberliegenden Zerspanwerkzeug dabei strukturiert werden.

Um mehrere längs- bzw. quer zur Bewegungsrichtung des Substrats verlaufende Trennfugen in elektrisch leitfähigen Bereichen gleichzeitig zu strukturieren, ist es in einer vorteilhaften Ausgestaltung der Erfindung vorgesehen, dass mehrere rotierende Zerspanwerkzeuge im Abstand zueinander auf einer gemeinsamen Antriebswelle angeordnet sind. Durch die gemeinsame Antriebswelle teilen sich die rotierenden Zerspanwerkzeuge nicht nur einen Antrieb, sondern werden darüber hinaus synchronisiert, so dass bei übereinstimmenden Zerspanwerkzeugen auch übereinstimmende Trennfugen gleichzeitig von den auf einer Antriebswelle angeordneten Zerspanwerkzeugen erzeugt werden.

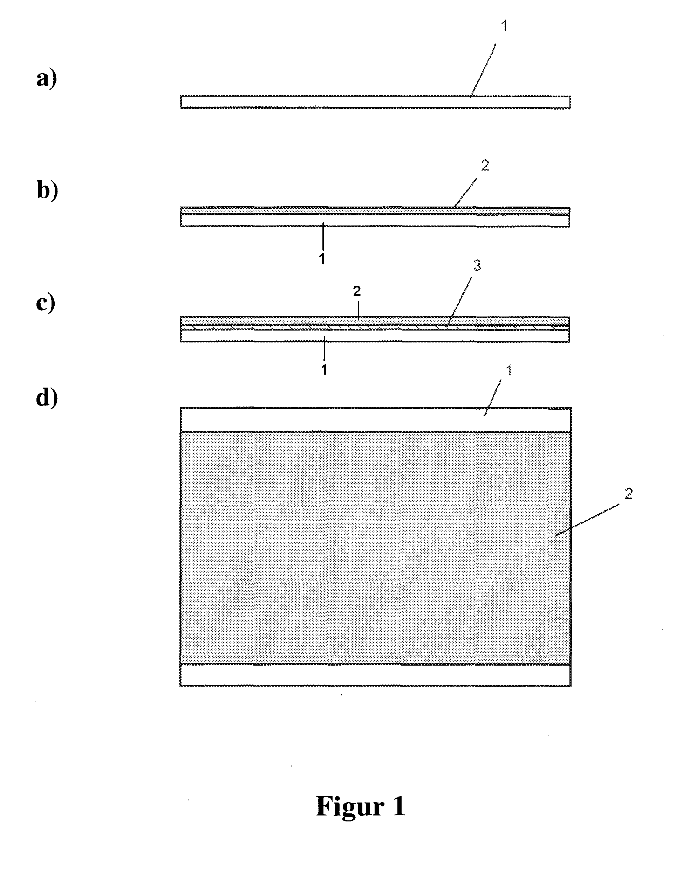

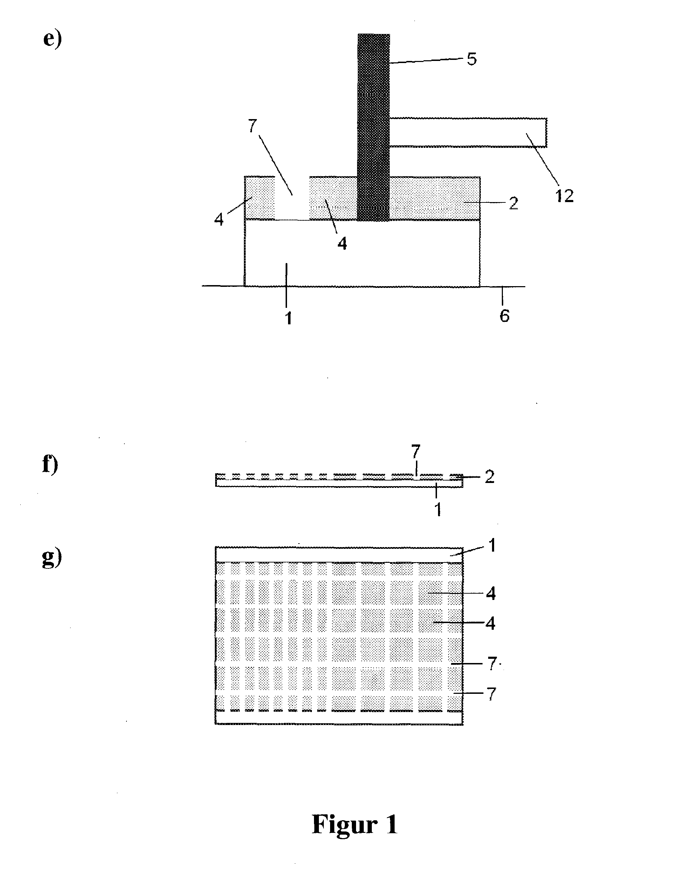

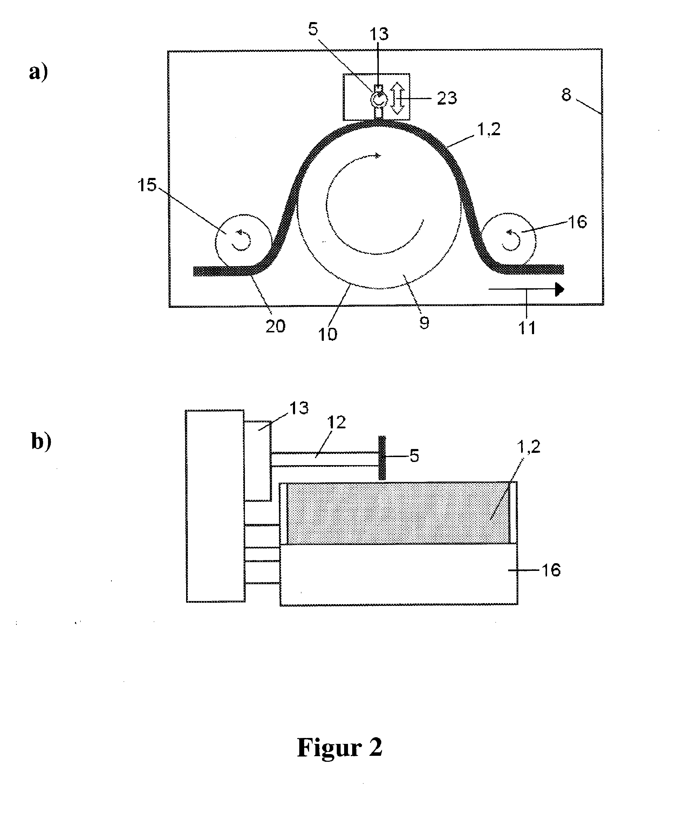

Nachfolgend werden Teilaspekte der Erfindung anhand der Figuren 2 - 4 und das erfindungsgemäße Verfahren sowie eine Vorrichtung zu dessen Durchführung anhand der Figuren 1, 5 und 6 näher erläutert. Es zeigen:
- **Figur 1a**: eine Seitenansicht eines Substrats,
- **Figur 1b**: eine Seitenansicht eines Substrats mit einer metallischen Lage,
- **Figur 1 c**: eine Seitenansicht eines aus einer Folie bestehenden Substrats mit einer als elektrisch leitfähige Folie ausgestalten Lage,
- **Figur 1 d**: eine Aufsicht auf das Substrat gem. Figur 1b,
- **Figur 1 e**: dessen elektrisch leitfähige Lage mit einem in Figur 1e dargestellten Zerspanwerkzeug strukturiert wird,
- **Figur 1 f**: die in Längs- und Querrichtung strukturierte elektrisch leitfähige Lage in einer Seitenahsicht und
- **Figur 1 g**: in einer Aufsicht,
- **Figur 2 a**: ein erstes illustratives Beispiel einer bekannten Vorrichtung zur Strukturierung einer leitfähigen Lage eines bahnförmigen Substrat in dessen Bewegungsrichtung,
- **Figur 2 b**: eine Vorderansicht der Vorrichtung nach Figur 2 a,

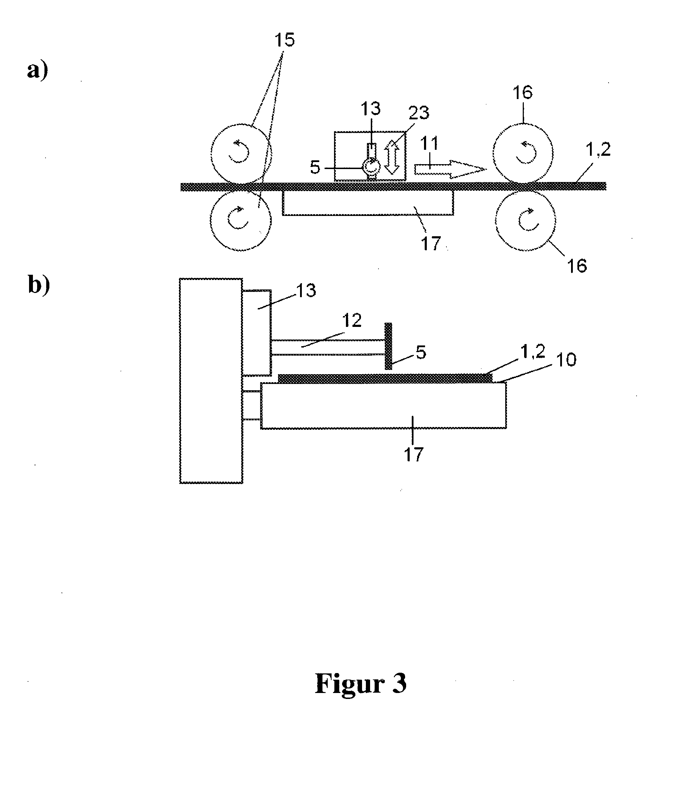

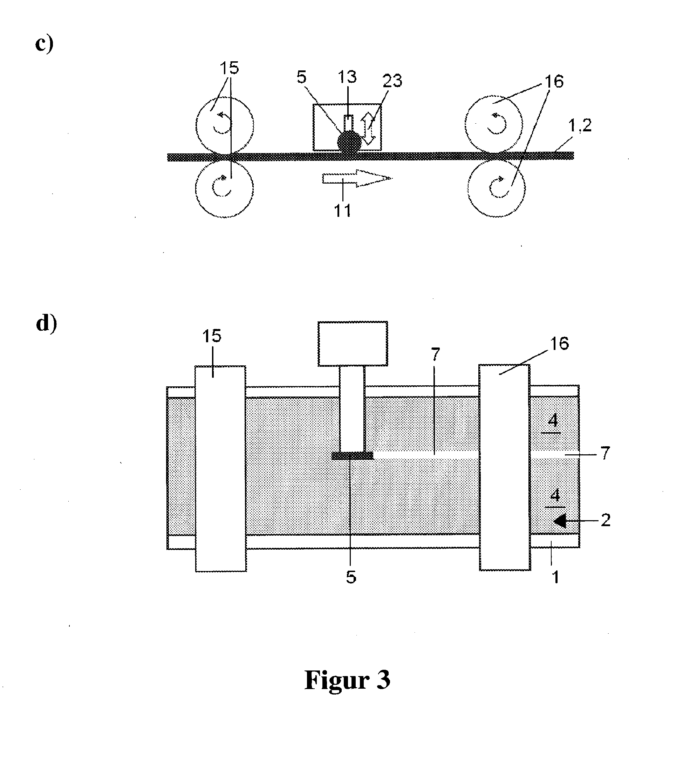

- **Figur 3 a**: ein zweites illustratives Beispiel einer bekannten Vorrichtung zur Strukturierung einer leitfähigen Lage eines bahnförmigen Substrats in dessen Bewegungsrichtung,
- **Figur 3 b**: eine Vorderansicht der Vorrichtung nach Figur 3 a,
- **Figur 3 c**: die Vorrichtung nach Figur 3 a mit abgesenktem Zerspanwerkzeug,
- **Figur 3 d**: eine Aufsicht auf die Vorrichtung nach Figur 3c,

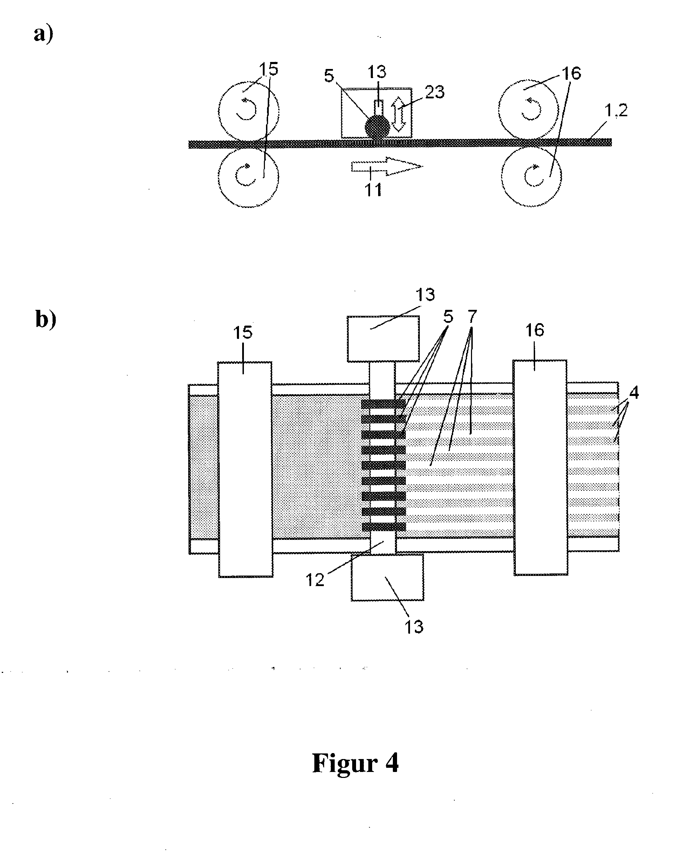

- **Figur 4 a**: ein drittes illustratives Beispiel einer bekannten Vorrichtung zur Strukturierung einer leitfähigen Lage eines bahnförmigen Substrats mit mehreren Zerspanwerkzeugen,
- **Figur 4 b**: eine Aufsicht auf die Vorrichtung nach Figur 4 a,

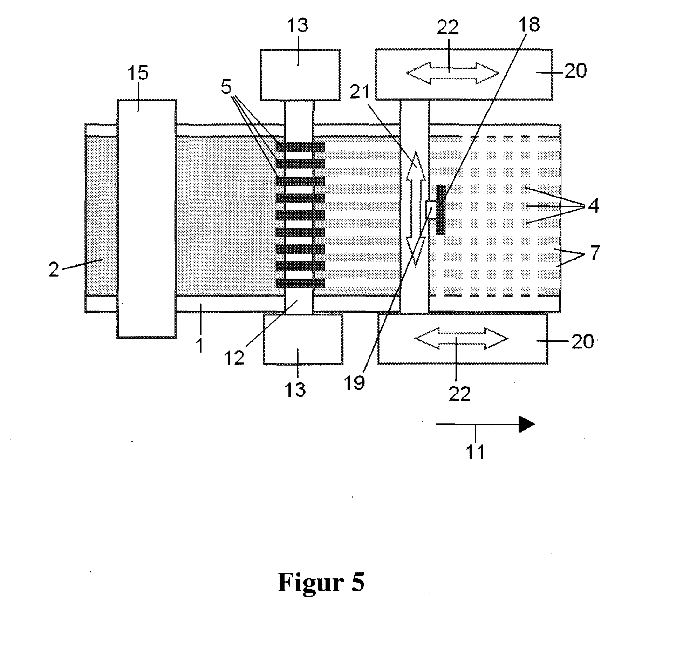

- **Figur 5**: eine Aufsicht auf ein Ausführungsbeispiel einer erfindungsgemäßen Vorrichtung zur Durchführung des erfindungsgemäßen Verfahrens mit einem gegenüber der nicht zur Erfindung gehörigen Vorrichtung nach Figur 4 weiteren, an einem separaten Positioniersystem angeordneten Zerspanwerkzeug, das quer und in Bewegungsrichtung des Substrats beweglich ist,

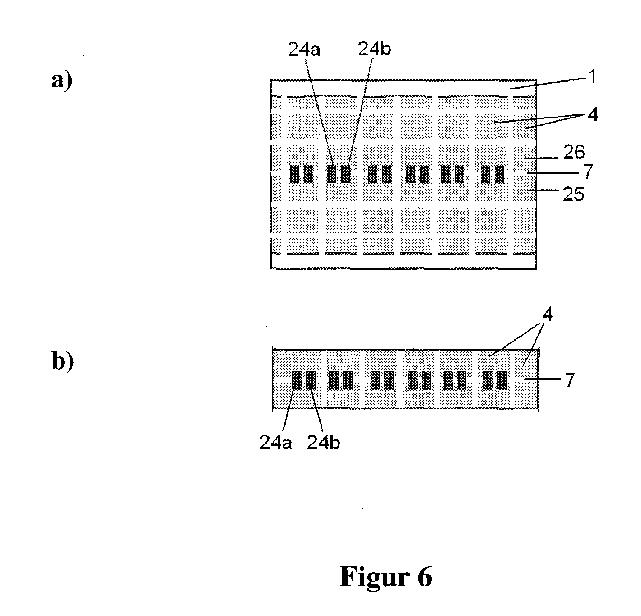

- **Figur 6 a**: eine Aufsicht auf ein Substrat mit strukturier Lage und Thermoelementen sowie
- **Figur 6 b**: ein aus der Struktur nach Figur 6 a herausgelöster Streifen.

Das erfindungsgemäße Verfahren dient der Strukturierung einer auf einem Substrat (1), insbesondere aus Kunststoff, angeordneten Lage (2), insbesondere aus einem elektrischen und thermisch leitfähigen Material. Die Lage (2) kann wie in Figur 1b dargestellt, im Wege eines Beschichtungsprozesses auf dem Substrat (1) abgeschieden werden. Alternativ besteht die Möglichkeit, dass sowohl das Substrat (1) als auch die Lage (2) von einer Folie gebildet werden, die mittels einer Klebeschicht (3) miteinander verbunden werden (Figur 1c). Produktionstechnisch ist es vorteilhaft, wenn das Substrat (1) die Lage (2) an den Längsrändern geringfügig überragt, wie dies in Figur 1d erkennbar ist.

Um die Lage (2) in mehrere voneinander getrennte Bereiche (4) zu unterteilen, wird diese mit Hilfe eines schematisch in Figur 1e dargestellten rotierenden Zerspanwerkzeug (5) zwischen den voneinander zu trennenden Bereichen (4) vollständig abgetragen, ohne jedoch das Substrat (1) zu durchtrennen.

Das Substrat (1) liegt auf der dem Zerspanwerkzeug (5) gegenüberliegenden Seite auf einer Oberfläche (6) auf. Diese Oberfläche (6) bildet eine Referenzoberfläche für das Zerspanwerkzeug (5), das soweit in Richtung der Oberfläche (6) bewegt wird, dass die Lage (2) unabhängig von etwaigen Toleranzen der Stärke des Substrats (1) stets vollständig abgetragen wird.

Um auf dem beschichteten Substrat (1) Thermoelemente platzieren zu können, wird die Lage (2) parallel und quer zur Längsrichtung der Lage (2) mit einem oder mehreren Zerspanwerkzeugen (5) strukturiert, so dass sich allseitig voneinander getrennte Bereiche (4) ergeben. Durch den vollständigen Abtrag der Lage (2) zwischen den Bereichen (4) ergeben sich zwischen den Bereichen (4) isolierende Trennfugen in Längs- und Querrichtung des Substrats (1).

Während und/oder nach dem Abtragen der Lage (2) wird das abgetragene Material beispielsweise mittels rotierender Bürsten oder durch Ultraschall entfernt.

Figur 2 a zeigt zur Erläuterung von Teilaspekten der Erfindung eine bekannte Vorrichtung (8) zur Strukturierung der Lage (2). Die Vorrichtung (8) weist einen drehbaren Positionierzylinder (9) auf, über dessen Oberfläche (10) das flexible Substrat (1) in einer Bewegungsrichtung (11) geführt wird. Der Positionierzylinder (9) ist ortsfest in der Vorrichtung (8) gelagert. Das als Fräswerkzeug ausgebildete Zerspanwerkzeug (5) ist über eine Welle (12) mit einem Drehantrieb verbunden. Das Zerspanwerkzeug (5) ist an einem Positioniersystem (13) angeordnet, das im dargestellten Ausführungsbeispiel als einachsiges Linearsystem ausgeführt ist, wobei das Zerspanwerkzeug (5) entlang der Z-Achse (23) des Linearsystems in Richtung der Oberfläche (10) des Positionierzylinders (9) oder von dessen Oberfläche weg bewegbar ist.

In den Figuren 2a, 2b ist das Zerspanwerkzeug (5) außer Eingriff. Um das Zerspanwerkzeug (5) in Eingriff zu bringen, wie dies beispielsweise aus Figur 1e erkennbar ist, wird das Zerspanwerkzeug mit dem Positioniersystem (13) in Richtung der Z-Achse (23) abgesenkt.

Die Führung des flexiblen beschichteten Substrats (1,2) über den Positionierzylinder (9) erfolgt mit Hilfe von Führungs- und Antriebsrollen (15, 16), die vorzugsweise auf beiden Seiten des beschichteten Substrats (1,2) angeordnet sind.

Figur 3 zeigt zur Erläuterung von Teilaspekten der Erfindung eine bekannte Vorrichtung, die sich von der Vorrichtung nach Figur 2 dadurch unterscheidet, dass das flexible, beschichtete Substrat (1,2) nicht über einen Positionierzylinder (9), sondern eine ortsfeste Positionierplatte (17) geführt wird, deren Oberfläche (10) als Referenzfläche für das an dem Positioniersystem (13) angeordnete Zerspanwerkzeug (5) dient. Der Antrieb des bahnförmigen Substrats (1,2) in Bewegungsrichtung (11) erfolgt über die Antriebsrollen (16).

Figuren 3a, 3b zeigen die Vorrichtung bei abgehobenem Zerspanwerkzeug (5). Um die Strukturierung der Lage (2) auf dem Substrat (1) vorzunehmen, muss das Zerspanwerkzeug (5) soweit in Richtung der Oberfläche (10) bewegt werden, dass das Zerspanwerkzeug (5) die Lage (2), wie aus den Figuren 3c, 3d erkennbar, vollständig abträgt, ohne jedoch das darunter befindliche Substrat (1) im Bereich der Trennfugen (7) nachhaltig zu schwächen. Die in Längsrichtung des bahnförmigen Substrats (1) verlaufende Trennfuge (7) in der Lage (2) wird erzeugt, indem das Substrat (1) gegenüber dem ortsfesten, rotierenden Zerspanwerkzeug (5) in Bewegungsrichtung (11) bewegt wird. Hierdurch wird das Zerspanwerkzeug relativ zu der Lage (2) in deren Ebene bewegt. Mit der Vorrichtung nach Figur 3 lässt sich die Lage (2) auf dem bahnförmigen Substrat (1) in zwei voneinander getrennte Bereiche (4) strukturieren.

Figur 4 zeigt zu Illustrationszwecken wie in einem Arbeitsgang mehr als zwei getrennte Bereiche (4) mit einer bekannten Vorrichtung erzeugt werden können. Die Vorrichtung nach Figur 4 unterscheidet sich von der Vorrichtung nach Figur 3 dadurch, dass insgesamt neun Zerspanwerkzeuge (5) in gleichmäßigem Abstand zueinander auf einer gemeinsamen Antriebswelle (12) angeordnet sind, die mit einem Drehantrieb verbunden ist. Die senkrecht zur Bewegungsrichtung (11) angeordnete Welle erzeugt mit den rotierenden Zerspanwerkzeugen (5) zehn durch die Trennfugen (7) voneinander getrennte Bereiche (4) in der Lage (2). Das Positioniersystem (13) ist vorzugsweise zu beiden Seiten der aus Gründen der Übersichtlichkeit nicht dargestellten Positionierplatte (17) angeordnet, um ein gleichmäßiges Anheben bzw. Absenken der Welle (12) mit den Zerspanwerkzeugen (5) sicherzustellen.

Die erfindungsgemäße Vorrichtung nach Figur 5 entspricht im Aufbau der Vorrichtung nach Figur 4, so dass auf die dortigen Ausführungen Bezug genommen wird. Zusätzlich'weist sie jedoch ein weiteres rotierendes Zerspanwerkzeug (18) auf, das auf einer rechtwinklig zu der Welle (12) verlaufenden Welle (19) angeordnet ist, die mit einem Antrieb verbunden ist. Dem Zerspanwerkzeug (18) ist ein separates Positioniersystem (20) zugeordnet. Es handelt sich um ein dreiachsiges Linearsystem, mit dem das Zerspanwerkzeug (18) quer und parallel zur Bewegungsrichtung (11) des Substrats in der Ebene der Lage (2) und senkrecht hierzu bewegbar ist. Um die Bereiche (4) nicht nur parallel zur Bewegungsrichtung (11), sondern erfindungsgemäß darüber hinaus auch orthogonal dazu zu unterteilen, wird das Zerspanwerkzeug (18) mit dem mehrachsigen Linearsystem (20) in Richtung der y-Achse (21) bewegt. Um während dieser Strukturierung den Vorschub des beschichten Substrats (1,2) nicht unterbrechen zu müssen, wird das sich entlang der y-Achse (21) bewegende Zerspanwerkzeug (18) von dem Positioniersystem (20) in Richtung der x-Achse (22) des Positioniersystems (20) mit übereinstimmender Geschwindigkeit und Bewegungsrichtung (11) wie das Substrat (1) bewegt.

Vor der nächsten Strukturierung in Richtung der y-Achse (21) wird das Zerspanwerkzeug (18) von dem Substrat (1) in Richtung der z-Achse (23) abgehoben und außer Funktion gebracht und entgegen der Bewegungsrichtung (11) mit dem Positioniersystem (20) in die Ausgangsposition verfahren. Sofern auf die x-Achse (22) des Positioniersystems (20) verzichtet werden soll, muss für die Strukturierung der Lage (2) in Richtung der y-Achse (21) der Vorschub des Substrats (1) kurzfristig unterbrochen werden. Hieraus resultiert ein quasi-kontinuierlicher Strukturierungsprozess mit kurzen Stillständen des Substrats (1).

Eine mit einer erfindungsgemäßen Vorrichtung nach Figur 5 strukturierte Lage (2) auf einem Substrat (1) ist insbesondere zur Herstellung eines Moduls mit mehreren elektrisch in Serie geschalteten Thermoelementen verwendbar. Jedes thermoelektrische Element (24 a, 24 b) ist als Dünnschicht-Thermoelement ausgeführt, das jeweils aus mindestens einer n-dotierten und mindestens einer p-dotierten Halbleiterschicht aus thermoelektrischem Material unter Ausbildung wenigstens eines sich entlang einer Grenzschicht ausbildenden pn-Übergangs besteht. Ein Temperaturgradient ist parallel zur Grenzschicht zwischen einer heißen und einer kalten Seite jedes thermoelektrischen Elementes (24) anlegbar.

Um diese thermoelektrischen Elemente (24) zu einem Modul miteinander zu verschalten, ist ein Substrat (1) mit mehreren elektrisch und thermisch leitfähigen Bereichen (4) erforderlich, die durch isolierende Trennfugen (7) zwischen den Bereichen (4) thermisch und elektrisch voneinander getrennt sind.

Um nun eine nach außen weisende p-Schicht des thermoelektrischen Elementes (24 a) mit einer nach außen weisenden n-Schicht des benachbarten thermoelektrischen Elementes (24 b) leitend miteinander zu verbinden, werden jeweils zwei benachbarte thermoelektrische Elemente (24 a, 24 b) an deren kalter Seite (25) mit einer thermisch und elektrisch leitenden Haftschicht mit einem der elektrisch und thermisch leitfähigen Bereiche (4) auf dem Substrat (1) elektrisch leitend verbunden. Auf der heißen Seite (26) werden jeweils zwei benachbarte thermoelektrische Elemente (24 ä, 24 b) ausschließlich thermisch an den Bereich (4) gekoppelt. Mit einer erfindungsgemäß strukturierten Lage (2) können jeweils zwei thermoelektrische Elemente (24 a, 24 b) elektrisch leitend in Reihe geschaltet werden und zugleich die Kontaktflächen zur Ein- bzw. Auskopplung thermischer Energie bereit gestellt werden.

**Bezugszeichenliste**

| **Nr.** | **Bezeichnung** |
|---|---|
| 1 | Substrat |
| 2 | Lage |
| 3 | Klebeschicht |
| 4 | getrennte Bereiche |
| 5 | Zerspanwerkzeug |
| 6 | Oberfläche |
| 7 | Trennfugen |
| 8 | Vorrichtung |
| 9 | Positionierzylinder |
| 10 | Oberfläche |
| 11 | Bewegungsrichtung |
| 12 | Welle |
| 13 | Positioniersystem |
| 14 | - |
| 15 | Führungsrollen |
| 16 | Antriebsrollen |
| 17 | Positionierplatte |
| 18 | Zerspanwerkzeug |
| 19 | Welle |
| 20 | Positioniersystem |
| 21 | y-Achse |
| 22 | x-Achse |
| 23 | z-Achse |
| 24 | TE-Element |
| 24 a, b | benachbarte TE-Elemente |
| 25 | kalte Seite |
| 26 | heiße Seite |

## Patentansprüche

1. Verfahren zur Strukturierung einer auf einem Substrat (1) angeordneten Lage (2) in mehrere voneinander getrennte Bereiche (4), wobei
- die Lage (2) zwischen voneinander zu trennenden Bereichen (4) mit Hilfe von mindestens einem ersten und mindestens einem zweiten Zerspanwerkzeug (5,18) abgetragen wird,
- das Substrat (1) auf der den Zerspanwerkzeugen (5, 18) gegenüberliegenden Seite auf einer Oberfläche (10) aufliegt,
- die Zerspanwerkzeuge (5, 18) so weit in Richtung der Oberfläche (10) und relativ zu der Lage (2) in deren Ebene bewegt werden dass die Lage (2) zwischen den voneinander zu trennenden Bereichen (4) vollständig abgetragen wird und
- die Relativbewegung jedes der vorgenannten ersten Zerspanwerkzeuge (5) in der Ebene der abzutragenden Lage durch eine gerichtete Bewegung des Substrats (1) in einer Bewegungsrichtung (11) erzeugt wird,
- durch den vollständigen Abtrag der Lage (2) zwischen den voneinander zu trennenden Bereichen (4) sich zwischen den Bereichen (4) isolierende Trennfugen in Längs- und Querrichtung des Substrats (1) ergeben,
- die Relativbewegung jedes der vorgenannten zweiten Zerspanwerkzeuge (18) in der Ebene der abzutragenden Lage (2) mit Hilfe eines Positioniersystem (20) dadurch erzeugt wird, dass jedes der vorgenannten zweiten Zerspanwerkzeuge (18) quer zu der Bewegungsrichtung (11) des Substrats (1) bewegt wird, wobei jedes sich quer zu der Bewegungsrichtung (11) des Substrats (1) bewegende zweite Zerspanwerkzeug (18) von dem Positioniersystem (20) zugleich mit übereinstimmender Geschwindigkeit und Bewegungsrichtung (11) wie das Substrat (1) bewegt wird
und
- das abgetragene Material entfernt wird.

2. Verfahren nach Anspruch 1, **dadurch gekennzeichnet, dass** das Substrat (1) über die Oberfläche (10) geführt wird.

3. Verfahren nach Anspruch 1 oder 2, **dadurch gekennzeichnet, dass** ein flexibles Substrat (1) verwendet wird.

4. Verfahren nach einem der Ansprüche 1 bis 3, **dadurch gekennzeichnet, dass** vor der Strukturierung die Lage (2) auf dem Substrat (1) als festhaftende Schicht aufgebracht wird.

5. Verfahren nach einem der Ansprüche 1 bis 3,**dadurch gekennzeichnet, dass** die zu strukturierende Lage (2) auf dem Substrat (1) als Folie aufgebracht wird.

6. Verfahren nach einem der Ansprüche 1 bis 5, **dadurch gekennzeichnet, dass** ein rotierendes Zerspanwerkzeug (5,18) verwendet wird.

7. Vorrichtung zur Strukturierung einer auf einem Substrat angeordneten Lage in mehrere getrennte Bereiche, wobei
- die Vorrichtung (8) mindestens eine ortsfeste Positioniereinrichtung (9, 17) mit einer Oberfläche (10) aufweist, über die das Substrat (1) in einer Bewegungsrichtung (11) führbar ist,
- die Vorrichtung mindestens ein erstes und mindestens ein zweites Zerspanwerkzeug (5, 18) zum Abtragen der auf dem Substrat (1) angeordneten Lage (2) aufweist,
- jedes der vorgenannten ersten Zerspanwerkzeuge (5) an einem Positioniersystem (13) angeordnet ist, mit dem das Zerspanwerkzeug (5, 18) zumindest in Richtung der Oberfläche (10) der Positioniereinrichtung (9, 17) oder von deren Oberfläche (10) weg bewegbar ist,
- jedes der vorgenannten zweiten Zerspanwerkzeuge (18) an einem Positioniersystem (20) angeordnet ist, das ein mehrachsiges Linearsystem ist, entlang dessen Achsen (21, 22, 23) jedes der vorgenannten zweiten Zerspanwerkzeuge (18) in Richtung der Oberfläche (10) der Positioniereinrichtung (9, 17) oder von deren Oberfläche weg und parallel zu deren Oberfläche bewegbar ist und
- die Vorrichtung eingerichtet ist, jedes der vorgenannten zweiten Zerspanwerkzeuge (18) quer zu der Bewegungsrichtung (11) des Substrates (1) mittels des Positioniersystems (20) so zu bewegen, dass sich jedes quer zur Bewegungsrichtung (11) des Substrats bewegende Zerspanwerkzeug (18) zugleich mit übereinstimmender Geschwindigkeit und Bewegungsrichtung (11) wie das Substrat bewegt und
- die Vorrichtung weiterhin eingerichtet ist, die Relativbewegung jedes der vorgenannten ersten Zerspanwerkzeuge (5) in der Ebene der abzutragenden Lage durch eine gerichtete Bewegung des Substrats (1) in einer Bewegungsrichtung (11) zu erzeugen.

8. Vorrichtung nach Anspruch 7, **dadurch gekennzeichnet, dass**
- jedes der vorgenannten zweiten Zerspanwerkzeuge (18) entlang der z-Achse (23) des mehrachsigen Linearsystems in Richtung der Oberfläche (10) der Positioniereinrichtung (9, 17) oder von deren Oberfläche (10) weg bewegbar ist,
- jedes der vorgenannten zweiten Zerspanwerkzeuge (18) entlang der Y-Achse (21) des mehrachsigen Linearsystems quer zur Bewegungsrichtung (11) des Substrats (1) bewegbar ist und
- jedes der vorgenannten zweiten Zerspanwerkzeuge (18) entlang der X-Achse (21) des mehrachsigen Linearsystems parallel zur Bewegungsrichtung (11) des Substrats (1) bewegbar ist.

9. Vorrichtung nach Anspruch 7 oder 8, **dadurch gekennzeichnet, dass** jedes rotierende Zerspanwerkzeug (5, 18) mit einem Drehantrieb verbunden ist.

10. Vorrichtung nach Anspruch 9, **dadurch gekennzeichnet, dass** mehrere rotierende Zerspanwerkzeuge (5) im Abstand zueinander auf einer gemeinsamen Antriebswelle (12) angeordnet sind.

## Claims

1. Method for structuring a layer (2) arranged on a substrate (1) in a plurality of separated regions (4), wherein
- the layer (2) between regions (4) to be separated from one another is removed with the aid of at least one first and at least one second cutting tool (5, 18),
- the substrate (1) lies on a surface (10) on the side opposite the cutting tools (5, 18),
- the cutting tools (5, 18) are moved so far in the direction of the surface (10) and relative to the layer (2) in the plane thereof that the layer (2) is completely removed between the regions (4) to be separated from one another and
- the relative movement of each of the aforesaid first cutting tools (5) in the plane of the layer to be removed is produced by a directional movement of the substrate (1) in a direction of movement (11),
- as a result of the complete movement of the layer (2) between the regions (4) to be separated from one another, isolating parting lines are formed between the regions (4) in the longitudinal and transverse direction of the substrate (1),
- the relative movement of each of the aforesaid second cutting tools (18) in the plane of the layer (2) to be removed is produced with the aid of a positioning system (20) whereby each of the aforesaid second cutting tools (18) is moved transversely to the direction of movement (11) of the substrate (1), wherein each second cutting tool (18) moving transversely to the direction of movement (11) of the substrate (1) is moved by the positioning system (20) at the same time as the substrate (1) with the same speed and direction of movement (11)
and
- the removed material is removed.

2. The method according to claim 1, **characterised in that** the substrate (1) is guided over the surface (10).

3. The method according to claim 1 or 2, **characterised in that** a flexible substrate (1) is used.

4. The method according to according to any one of claims 1 to 3, **characterised in that** before the structuring, the layer (2) is applied to the substrate (1) as a firmly adhering layer.

5. The method according to according to any one of claims 1 to 3, **characterised in that** the layer (2) to be structured is applied to the substrate (1) as a film.

6. The method according to according to any one of claims 1 to 5, **characterised in that** a rotating cutting tool (5, 18) is used.

7. Apparatus for structuring a layer arranged on a substrate in a plurality of separated regions, wherein
- the apparatus (8) comprises at least one fixed positioning device (9, 17) having a surface (10) over which the substrate (1) can be guided in one direction of movement (11),
- the apparatus comprises at least one first and at least one second cutting tool (5, 18) for removal of the layer (2) arranged on the substrate (1),
- each of the aforesaid first cutting tools (5) is arranged on a positioning system (13) with which the cutting tool (5, 18) can be moved at least in the direction of the surface (10) of the positioning device (9, 17) or away from the surface (10) thereof,
- each of the aforesaid second cutting tools (18) is arranged on a positioning system (20) which is a multi-axial linear system along the axes (21, 22, 23) whereof each of the aforesaid second cutting tools (18) can be moved in the direction of the surface (10) of the positioning device (9, 17) or away from the surface thereof and parallel to the surface thereof and
- the apparatus is adapted to move each of the aforesaid second cutting tools (18) moving transversely to the direction of movement (11) of the substrate (1) by means of the positioning system (20) so that each cutting tool (18) moving transversely to the direction of movement (11) of the substrate is moved at the same time at the same speed and direction of movement (11) as the substrate and
- the apparatus is further adapted to produce the relative movement of each of the aforesaid first cutting tools (5) in the plane of the layer to be removed by a directional movement of the substrate (1) in a direction of movement (11).

8. The apparatus according to claim 7, **characterised in that**
- each of the aforesaid second cutting tools (18) can be moved along the z axis (23) of the multi-axial linear system in the direction of the surface (10) of the positioning device (9, 17) or away from the surface (10) thereof,
- each of the aforesaid second cutting tools (18) can be moved along the Y axis (21) of the multi-axial linear system transversely to the direction of movement (11) of the substrate (1) and
- each of the aforesaid second cutting tools (18) can be moved along the X axis (21) of the multi-axial linear system parallel to the direction of movement (11) of the substrate (1).

9. The apparatus according to claim 7 or 8, **characterised in that** each rotating cutting tool (5, 18) is connected to a rotary drive.

10. The apparatus according to claim 9, **characterised in that** a plurality of rotating cutting tools (5) are arranged at a distance from one another on a common drive shaft (12).

## Revendications

1. Procédé destiné à structurer une couche (2) disposée sur un substrat (1) en plusieurs zones (4) séparées les unes des autres, lors duquel
- on enlève la couche (2) entre deux zones (4) devant être séparées l'une de l'autre à l'aide d'au moins un premier et d'au moins un deuxième outil d'enlèvement de copeaux (5, 18),
- sur le côté opposé aux outils d'enlèvement de copeaux (5, 18), le substrat (1) reposant sur une surface (10),
- on déplace les outils d'enlèvement de copeaux (5, 18) en direction de la surface (10) et par rapport à la couche (2) dans le plan de cette dernière, de telle sorte que la couche (2) entre les zones (4) devant être séparées l'une de l'autre soit complètement enlevée et
- on créé le déplacement relatif de chacun des outils d'enlèvement de copeaux (5) précédemment cités dans le plan de la couche à enlever par un déplacement orienté du substrat (1) dans un sens de déplacement (11),
- par l'enlèvement complet de la couche (2) entre les zones (4) devant être séparées l'une de l'autre, il en résulte entre les zones (4) des joints de séparation isolants en direction longitudinale et en direction transversale du substrat (1),
- on créé le déplacement relatif de chacun des outils d'enlèvement de copeaux (18) précédemment cités dans le plan de la couche (2) à enlever à l'aide d'un système de positionnement (20) en déplaçant chacune des outils d'enlèvement de copeaux (18) précédemment cités à la transversale du sens de déplacement (11) du substrat (1), chaque deuxième outil d'enlèvement de copeaux (18) se déplaçant à la transversale du sens de déplacement (11) du substrat (1) étant déplacé par le système de positionnement (20) simultanément et avec une vitesse et un sens de déplacement (11) concordants à ceux du substrat (1)
et
- on retire la matière enlevée.

2. Procédé selon la revendication 1, **caractérisé en ce qu'**on guide le substrat (1) par-dessus la surface (10).

3. Procédé selon la revendication 1 ou la revendication 2, **caractérisé en ce qu'**on utilise un substrat (1) flexible.

4. Procédé selon l'une quelconque des revendications 1 à 3, **caractérisé en ce qu'**avant la structuration, on applique la couche (2) en tant que couche adhérente sur le substrat (1).

5. Procédé selon l'une quelconque des revendications 1 à 3, **caractérisé en ce qu'**on applique la couche (2) à structurer en tant que film sur le substrat (1).

6. Procédé selon l'une quelconque des revendications 1 à 5, **caractérisé en ce qu'**on utilise un outil d'enlèvement de copeaux (5, 18) rotatif.

7. Dispositif destiné à structurer en plusieurs zones une couche disposée sur un substrat
- le dispositif (8) comportant au moins un système de positionnement (9, 17) stationnaire avec une surface (10), par-dessus laquelle le substrat (1) peut être guidé dans un sens de déplacement (11),
- le dispositif comportant au moins un premier et au moins un deuxième outil d'enlèvement de copeaux (5, 18) pour enlever la couche (2) disposée sur le substrat (1)
- chacun des premiers outils d'enlèvement de copeaux (5) précités étant disposé sur un système de positionnement (13), à l'aide duquel l'outil d'enlèvement de copeaux (5, 18) est déplaçable au moins en direction de la surface (10) du système de positionnement (9, 17) ou en s'éloignant de la surface (10) de ce dernier,
- chacun des deuxièmes outils d'enlèvement de copeaux (18) précités étant disposé sur un système de positionnement (2C) qui est un système linéaire à plusieurs axes, le long des axes (21, 22, 23) duquel chacun des deuxièmes outils d'enlèvement de copeaux (18) précités est mobile en direction de la surface (10) du système de positionnement (9, 17) ou en s'éloignant de sa surface et à la parallèle de sa surface et
- le dispositif étant installé pour déplacer chacun des deuxièmes outils d'enlèvement de copeaux (18) précités à la transversale du sens de déplacement (11) du substrat (1) au moyen du système de positionnement (20), de telle sorte que chacun des outils d'enlèvement de copeaux (18) devant être déplacé à la transversale du sens de déplacement (11) du substrat se déplace simultanément avec une vitesse et un sens de déplacement (11) concordants à ceux du substrat et
- le dispositif étant installé par ailleurs pour générer le déplacement relatif de chacun des premiers outils d'enlèvement de copeaux (5) précités dans le plan de la couche devant être enlevée par un déplacement orienté du substrat (1) dans un sens de déplacement (11).

8. Dispositif selon la revendication 7, **caractérisé en ce que**
- chacun des deuxièmes outils d'enlèvement de copeaux (18) précités est mobile le long de l'axe Z (23) du système linéaire à plusieurs axes, en direction de la surface (10) du système de positionnement (9, 17) ou en s'éloignant de la surface (10) de ce dernier,
- chacun des deuxièmes outils d'enlèvement de copeaux (18) est mobile le long de l'axe Y (21) du système linéaire à plusieurs axes, à la transversale du sens de déplacement (11) du substrat (1) et
- chacun des deuxièmes outils d'enlèvement de copeaux (18) est mobile le long de l'axe X (21) du système linéaire à plusieurs axes, à la parallèle du sens de déplacement (11) du substrat (1).

9. Dispositif selon la revendication 7 ou la revendication 8, **caractérisé en ce que** chaque outil d'enlèvement de copeaux (5, 18) rotatif est relié avec un entraînement en rotation.

10. Dispositif selon la revendication 9, **caractérisé en ce que** plusieurs outils d'enlèvement de copeaux (5) rotatifs sont disposés avec un écart mutuel sur un arbre d'entraînement (12) commun.
